# EUROPÄISCHE PATENTANMELDUNG

(11) **EP 2 421 339 A1**
(43) Veröffentlichungstag der Anmeldung: **22.02.2012**
(21) Anmeldenummer: 11172305.2
(22) Anmeldetag: 01.07.2011
(51) Int. Cl.: H05K 1/18

(54) **Verfahren zum Einbetten von elektrischen Komponenten**

(30) Priorität: 18.08.2010 DE 102010037054
(71) Anmelder: Dyconex AG, 8303 Bassersdorf (CH)
(72) Erfinder: Hauer, Marc, 8050 Zürich (CH); Riester, Markus, 8054 Seiersberg (AT)
(74) Vertreter: Lindner-Vogt, Karin L.

(57) **Zusammenfassung**

Verfahren zur Einbettung von zumindest einer Komponente (101, 201) in eine dielektrische Lage (106, 206).

Um einen gutes Ergebnis zu erreichen, wird vorgeschlagen, dass das Verfahren die folgenden Schritte umfasst: a) Positionieren und Fixieren der zumindest einen Komponente (101, 201) auf einem Träger (103, 103a, 203); b) Umgießen der zumindest einen Komponente (101, 201) mit einem flüssigen Dielektrikum (104, 204), so dass die zumindest eine Komponente (101, 201) vollständig umschlossen wird; c) Aushärten des flüssigen Dielektrikums (104, 204) zu einer festen dielektrischen Lage (106, 206); und d) Aufbringen, insbesondere Auflaminieren, einer weiteren Lage (105, 205), insbesondere einer elektrisch leitfähigen Lage (117, 217).

Verwendung einer komplett aus flüssigem Dielektrikum (104, 204) aufgebauten dielektrischen Lage (106, 206), wobei das flüssige Dielektrikum (104, 204) erst bei der Prozessierung des Dielektrikums in einen festen Zustand überführt wird.

## Beschreibung

Die Erfindung betrifft ein Verfahren zum Einbetten von elektrischen Komponenten in einer Leiterplatte nach den Oberbegriffen der unabhängigen Ansprüche.

Aus dem Stand der Technik ist bekannt, dass die dielektrischen Materialien für eine Leiterplatte als strukturierte oder unstrukturierte Folie vorliegen. Im ersten Fall umfließt während des Aufheizens und Verpressens das Material die auf dem Substrat bestückten Komponenten und umschließt diese. Im zweiten Fall werden die Folien mit Aussparungen über die Komponenten platziert. Bei sehr dünnen Komponenten können die Komponenten direkt in diese Folie hineingepresst werden.

Bei dickeren Komponenten muss das Dielektrikum vorgefräst werden. Weiterhin muss, um die Komponenten völlig zu umschließen, meist mit mehreren übereinander angeordneten Dielektrikumsfolien gearbeitet werden.

Nachteilig ist, dass das Material beim Verpressen in die Aussparung fließt und so die Komponenten vollständig umhüllt. In den Fällen, in denen das Volumen der Kavität so groß ist, dass die Menge an Material nicht ausreicht um die Kavität zu füllen wird zusätzliches flüssiges Material in die Kavität eingefüllt, so dass weniger Material aus dem Folienmaterial benötigt wird.

In wieder anderen bekannten Verfahren werden Halbleiterprozesse (so genanntes "Spin Coating" bzw. (Aufschleudern)) genutzt, um flüssige Dielektrika planar aufzubringen. Diese Verfahren werden auch für das Einbetten von einzelnen oder mehreren Chips verwendet. Allerdings sind nur relativ geringe Dicken von weniger als 20 µm möglich. Größere Dicken, wie sie durch Siebdruck oder Rakeln erzielt werden können, sind nicht möglich. Die US 2008/0123318 A1 beschreibt ein Verfahren zu einem Zusammenbauen einer Leiterplatte. Hierbei wird ein Substrat, welches Ausnehmungen aufweist, auf einer Vakuumplatte positioniert. Nach einem Einsetzen von Komponenten in die Ausnehmungen werden die freigebliebenen Hohlräume der Ausnehmungen zu einer Fixierung der Komponenten mit einem Klebstoff aufgefüllt. Im Anschluss daran werden nach einem Entfernen der Vakuumplatte je ein Metallfilm auf eine Vorder- und eine Rückseite des Substrats aufgebracht.

Deshalb ist ausgehend vom Stand der Technik die Aufgabe, die Komponenten dielektrisch einzubetten, ohne dass unnötige Kräfte auf sie wirken und ohne dass eine Folie vorgefräst werden muss. Weiterhin sollte die Methode in der Lage sein Komponenten von unterschiedlicher Größe und Dicke gleichzeitig zu umschließen.

Die Aufgabe wird erfindungsgemäß durch ein Verfahren mit den Merkmalen der unabhängigen Ansprüche gelöst. Zudem wird die Aufgabe durch die Verwendung einer komplett aus flüssigem Dielektrikum aufgebaut dielektrischen Lage gelöst, wobei das flüssige Dielektrikum erst bei der Prozessierung des Dielektrikums in einen festen Zustand überführt wird.

Günstige Ausgestaltungen und Vorteile der Erfindung ergeben sich aus den weiteren Ansprüchen, der Zeichnung und der Beschreibung.

Die Erfindung geht aus von einem Verfahren zur Einbettung von zumindest einer Komponente in eine dielektrische Lage.

Es wird vorgeschlagen, dass das Verfahren die folgenden Schritte umfasst: a) Positionieren und Fixieren der zumindest einen Komponente auf einem Träger; b) Umgießen der zumindest einen Komponente mit einem flüssigen Dielektrikum, so dass die zumindest eine Komponente vollständig umschlossen wird; c) Aushärten des flüssigen Dielektrikums zu einer festen dielektrischen Lage; und d) Aufbringen, insbesondere Auflaminieren einer weiteren Lage, insbesondere einer elektrisch leitfähigen Lage.

Durch das erfindungsgemäße Verfahren können Komponenten vorteilhaft in eine dielektrische Lage eingebettet werden, wodurch eine kompakte Leiterplatte gefertigt werden kann. Mittels dieses Verfahrens kann auf einen Einsatz von vorgefrästen Folien verzichtet werden. Ferner entfällt eine Vorstrukturierung von Folien, wodurch Arbeitsaufwand und Kosten eingespart werden können. Des Weiteren kann das Einbetten gezielt auf ein Komponentenvolumen abgestimmt werden, wodurch auf vorgefertigte Folien unterschiedlicher Dicken völlig verzichtet werden kann. Hierdurch ist das Verfahren auch unabhängig von einer Verfügbarkeit von Dielektrika, insbesondere Folien, bestimmter Dicken. Zudem kann so ein Umschließen der Komponenten von unterschiedlicher Größe und Dicke prozesssicher gleichzeitig erfolgen. Bei diesem Einbettungsprozess werden die Komponenten in dem Träger vergossen, wodurch sich ein kleineres Volumen ergibt. Somit ermöglicht das Verfahren eine einfache Miniaturisierung von elektrischen Aufbauten. Zudem kann ein Fertigungsformat um ein bis zwei Größenordnungen größer sein als bei einem Packagingprozessen des Standes der Technik.

Das Aufbringen einer weiteren Lage auf das Dielektrikum kann insbesondere durch Auflaminieren erfolgen. Beim Laminieren wird eine folienartige Schicht mit einem Kleber auf eine Oberfläche aufgebracht. Denkbar sind selbstverständlich auch andere Beschichtungsverfahren wie Siebdruck, Galvanisieren, oder auch Vakuumbeschichtungsverfahren wie Aufdampfen oder Beschichten mittels Kathodenzerstäubung. Die weitere Lage kann dann z.B. so strukturiert werden, beispielsweise durch übliche Ätzprozesse, dass Leiterbahnen gebildet werden, um die eingebetteten Komponenten zu kontaktieren. Die Kontakte werden dazu entsprechend freigelegt, etwa mittels nasschemischen oder ionengestützten Ätzverfahren.

Vorteilhaft können auch relativ kleine Strukturen, etwa Kontaktbahnen zu Anschlüssen der Komponenten erzeugt werden, wobei die erzielbare Zahl von Anschlüssen lediglich von der Güte der Photoprozesse und der Beschichtung abhängig ist.

Das Einbetten erfolgt während des Fertigungsprozesses der Leiterplatte und ermöglicht so die Herstellung von "Embedded Cores" (EDC), d.h. Leiterplattenkerne mit eingebetteten

Komponenten, oder generell EDC in jeder Aufbaulage einer sequentiell aufgebauten Leiterplatte. Unter "flüssig" soll hier verstanden werden, dass ein Aggregatszustand eines betreffenden Stoffs nicht fest ist und/oder dass der Stoff fließfähig ist. Hierunter fällt auch ein viskoser Stoff. Der Stoff ist insbesondere im Prozess des Umgießens flüssig. Unter "Aushärten" soll hier verstanden werden, dass der Aggregatszustand des Stoffs von flüssig zu fest übergeht. Das Aushärten erfolgt infolge eines chemischen oder physikalischen Impulses, wie beispielsweise einer Zugabe eines Radikalstarters, einer Änderung eines pH-Werts, Zeit, Temperatur, Strahlung (UV-, VIS-, IR-, Röntgen-, radioaktive Strahlung) und insbesondere durch eine Temperaturänderung, besonders bevorzugt eine Temperaturerhöhung. Bei dem Umgießen wird das Dielektrikum über das komplette Fertigungsformat bzw. Fertigungspanel aufgebracht. Den Verfahrensschritten a) bis d) können weitere Schritte folgen, wie beispielsweise Schritt e) zum elektrischen Anschließen der Komponenten unter Nutzung von bekannten Leiterplattenprozessen.

Vorteilhaft wird das Dielektrikum mit einer Mindestdicke von 10 µm (im ausgehärteten Zustand), mit einer maximalen Dicke von 1000 µm und einer bevorzugten Dicke von 30 - 250 µm ausgebildet. In diesem Zusammenhang soll unter einer "Dicke" eine Ersteckung des Dielektrikums senkrecht zu einer Ebene des Trägers verstanden werden. Hierbei stellt die Ebene die Fläche des Trägers dar, auf der die Komponente fixiert wird. Durch diese Dicke können auf den Träger aufgebrachte Komponenten vollständig umschlossen werden, wodurch diese vor schädigenden Umwelteinflüssen geschützt sind. Ferner sind sie demgemäß eingebettet, so dass keine Kräfte auf sie wirken können.

Des Weiteren wird vorgeschlagen, dass das Dielektrikum aus einem Thermoplast und/oder einem Duroplast gebildet wird. Hierbei können alle dem Fachmann für anwendbar erachtete Thermoplaste und/oder Duroplaste zum Einsatz kommen. Bevorzugt wird das Dielektrikum jedoch aus einem Element aus der Gruppe bestehend aus: Polyimid, Epoxidharz, Polyesterharz, Polyurethan und Aminoharz und besonders bevorzugt von einem Polyimid, wie beispielsweise Sunflex von Sun Chemical, gebildet. Grundsätzlich könnte das Dielektrikum auch aus einem anderen Material für die Fertigung von Leiterplatten sein. Mittels des verwendeten Materials können Umwelt- und Prozesseinflüsse, wie sie aus der Leiterplattenfertigung bekannt sind, einfach überwunden werden.

In einer weiteren Ausgestaltung der Erfindung wird vorgeschlagen, dass der Träger von zumindest einer ersten elektrisch leitfähigen Lage gebildet wird. Besonders vorteilhaft wird der Träger aus einer Metallfolie, insbesondere einer dünnen Metallfolie gebildet bzw. weist dieser zumindest eine Metallfolie auf. Die Metallfolie wird temporär auf einem dicken Metallblech fixiert. Nach dem Laminieren der weiteren elektrisch leitfähigen Lage nach Aufbringen des Dielektrikums kann der Träger von der dünnen Metallfolie getrennt werden. Durch die Ausgestaltung des Trägers als elektrisch leitfähige Lage kann der Träger zwei Funktionen Bauteil sparend übernehmen. Prozess vereinfachend ist zum Zeitpunkt der Einbettung der Komponenten der Träger unstrukturiert bzw. nicht strukturiert.

Alternativ kann der Träger ein integraler Bestandteil eines Leiterplattenaufbaus sein, welcher von einer weiteren Lage der Leiterplatte gebildet wird. Die Verfahrensschritte a) bis d) und ein weiterer Verfahrensschritt e) zum elektrischen Anschluss der Komponenten unter Nutzung von bekannten Leiterplattenprozessen können sich je nach Zahl der notwendigen Lagen wiederholen. Durch die Ausgestaltung des Trägers als weitere Lage der Leiterplatte kann eine Fertigung einer sequentiell aufgebauten Leiterplatte konstruktiv einfach mit weniger Prozessschritten Bauteil und Kosten sparend erfolgen, als bei einem Fertigungsprozess mit zusätzlichem Träger.

Ferner ist es vorteilhaft, wenn die weitere Lage, insbesondere weitere elektrisch leitfähige Lage, gebildet wird aus einem Element der Gruppe bestehend aus einer Metallfolie, einer thermoplastischen Polymerfolie oder eines metallkaschierten Duromeres. Grundsätzlich wäre jedoch jede andere, vom Fachmann für sinnvoll erachtete leitfähige Lage denkbar. Die Metallfolie ist insbesondere eine Kupferfolie. Das Aufbringen von Kupfer entweder auf dem ganzen Fertigungsformat mit einem Subtraktivprozess oder in vorstrukturierte Kavitäten in einer Opferschicht kann z.B. mittels galvanischer Prozesse erfolgen, wie sie aus dem Stand der Technik bekannt sind. Der Subtraktivprozess ist ein weitverbreitetes Verfahren bei der Herstellung eines strukturierten Leiterbilds und umfasst das partielle Entfernen von Teilen einer leitenden Folie bzw. durch selektives Abätzen der unerwünschten Teile einer leitenden Kaschierung. Die Kupferfolie kann nach der Aufbringung strukturiert werden. Mittels der erfindungsgemäßen Ausgestaltung und insbesondere mit der Kupferfolie kann eine elektrische Ankontaktierung der eingebetteten Komponenten konstruktiv einfach erfolgen. Zudem ist ein Volumen, das für ein solches Ankontaktieren benötigt wird, deutlich kleiner als ein Volumen, das bei Techniken des Standes der Technik, wie Drahtbonden, Löten oder Kleben, benötigt wird.

Zusätzlich kann mindestens eine weitere dielektrische Klebeschichtlage auf der ersten dielektrischen Lage vorgesehen werden. Diese zusätzliche Lage befindet sich bevorzugt auf der der elektrisch leitfähigen Lage zugewandten Seite. Diese wird zur Unterstützung der Auflaminierung der leitfähigen Schicht benutzt. Beispielsweise kann vor dem Laminierschritt mittels der Klebewirkung eine Vorfixierung erfolgen.

Das Umgießen kann mittels verschiedener, dem Fachmann für einsetzbar erachteter Beschichtungs- und Druckverfahren erfolgen. Es wird vorgeschlagen, dass das Umgießen mittels einem Verfahren durchgeführt wird aus der Gruppe bestehend aus Siebdruck, Rakelverfahren, "Curtain coating" (Aufbringen eines Sprühnebels auf eine Oberfläche), Laminierverfahren, Flexodruck oder Gravurdruck. Bevorzugt sind hierbei Siebdruck oder Rakeln. Mittels dieser Verfahren kann eine Technik eingesetzt werden, die gut etabliert ist und zu zuverlässigen Ergebnissen führt.

Vorteilhafterweise wird eine Komponente verwendet, die auf mindestens einer Seite zumindest einen elektrischen oder thermischen Kontakt aufweist. Praktischerweise hat die Komponente auf mindestens einer Seite mehrere elektrische oder thermische Kontakte Kontakte. Die zumindest eine Komponente wird mit zumindest einem elektrischen oder thermischen Kontakt nach oben orientiert und/oder nach unten orientiert und/oder seitlich orientiert auf dem Träger platziert, wodurch vorteilhaft eine große Einsatzbreite erreicht wird. Ferner wird vorgeschlagen, dass in einer Komponentenlage Komponenten mit einem elektrischen Kontakt unten und/oder oben und/oder seitlich und/oder mit mehreren elektrischen Kontakten unten und/oder oben und/oder seitlich gemischt angeordnet werden. Somit können Komponenten unterschiedlicher Art, also mit elektrischen oder thermischen Kontakten oben, elektrischen oder thermischen Kontakten unten, elektrischen oder thermischen Kontakten oben und unten sowie elektrischen oder thermischen Kontakten an der Seite auf einem Träger platziert werden. Durch die Realisierung dieser Ausgestaltung können verschiedene Komponenten unabhängig von ihrem individuellen Aufbau variabel verwendet werden.

Eine bevorzugte Weiterbildung besteht darin, dass das Verfahren einen Eingangsprozessschritt vor Schritt a) aufweist, bei dem auf den Träger ein Kleber aufgebracht wird, auf dem die Komponenten positioniert und fixiert werden. Alternativ und/oder zusätzlich kann bei dem Eingangsprozessschritt ein Kleber auf die Komponenten aufgebracht werden, mit dem sie auf den Träger geklebt werden. Der Kleber kann ein Flüssigkleber oder ein Folienkleber sein. Er kann bevorzugt leitend oder nicht leitend sein und/oder besonders bevorzugt unstrukturiert oder strukturiert auf den Träger oder die Komponente aufgebracht werden. Generell wäre auch jeder andere, vom Fachmann für anwendbar erachtete Kleber denkbar.

Ein funktional stimmiger Aufbau kann vorteilhaft erreicht werden, wenn die zumindest eine, erfindungsgemäß eingebettete, Komponente an die leitfähigen Lagen mittels plattierten Löchern zwischen den Lagen oder mittels Leitkleber elektrisch angeschlossen wird. Eine Erzeugung einer z-Achsenverbindung (durch das Dielektrikum und die weitere Lage) erfolgt über Bohren von Löchern, bevorzugt mittels Plasma- oder Laserbohrverfahren.

Es wird zudem vorgeschlagen, dass die zumindest eine Komponente gebildet wird von einer elektrischen Komponente und/oder insbesondere von einer Komponente aus der Gruppe bestehend aus ICs (integrierten Schaltkreisen), IPDs (Integrierte Passive Komponenten), ASICs (Anwendungsspezifischer Integrierter Schaltkreis) oder flache passive Komponenten. Die Komponente kann Teil einer Baugruppe ("Die Stack") sein, oder auch eine diskrete Komponente, die auf diese Weise in ein Package eingebracht wird, etwa Widerstände, Kondensatoren, Induktivitäten und dergleichen. Somit können vielfältige Komponenten mittels des erfindungsgemäßen Verfahrens eingebettet werden. Ferner wird vorgeschlagen, dass die zumindest eine Komponente gebildet wird aus einer "thermischen Komponente", also Bautteile, die eine hohe Wärmeabgabe aufweisen. Dies können beispielsweise Leistungsverstärker sein, deren Wärme mittels thermischer Kontakte wie beispielsweise thermischen Vias abgeführt werden. Thermische Vias im Sinne der Patentanmeldung sind Durchkontaktierungen ohne elektrische Funktion, die beispielsweise aus Kupfer als Wärmeleitmaterial bestehen. Ebenfalls anwendbar sind Komponenten, welche über elektrische Felder angesprochen werden wie beispielsweise RFID-Chips ("Radiofrequency Identification"-Chips). Diese Komponenten benötigen keine strukturellen elektrischen oder thermischen Anschlüsse.

Ferner geht die Erfindung aus von einem Verfahren zur Einbettung von Komponenten in eine dielektrische Lage. Es wird vorgeschlagen, dass das Verfahren die folgenden Schritte aufweist: a) Positionieren und Fixieren der Komponenten auf einem Träger; b) Umgießen der Komponenten mit einem flüssigen Dielektrikum, so dass die Komponenten vollständig umschlossen werden, wobei das Dielektrikum die folgenden Werte aufweist: i. Mindestdicke 10 µm (im ausgehärteten Zustand); ii. Maximale Dicke 1000 µm, iii. Bevorzugte Dicke: 30 - 250 µm, c) Aushärten des Dielektrikums zu einer festen dielektrischen Lage; und d) Aufbringen, insbesondere Auflaminieren, einer weiteren insbesondere elektrisch leitfähigen Lage. In einer abgewandelten Ausführungsform können die Prozesse c+d auch in einem gleichen Prozessschritt stattfinden. Den Verfahrensschritten a) bis d) können weitere Schritte folgen, wie beispielsweise Schritt e) zum elektrischen Anschließen der Komponenten unter Nutzung von bekannten Leiterplattenprozessen.

Des Weiteren geht die Erfindung aus von einer Verwendung einer komplett aus flüssigem Dielektrikum aufgebauten dielektrischen Lage, wobei das flüssige Dielektrikum erst bei der Prozessierung des Dielektrikums in einen festen Zustand überführt wird.

Durch die Verwendung des flüssigen Dielektrikums und die genannten Verfahren ist sichergestellt, dass ein beliebiges Komponentenvolumen mit Dielektrikum umschlossen werden kann, ohne das große Kräfte beim einbetten auftreten, welche die Komponenten schädigen.

Die Erfindung ist nachfolgend beispielhaft, anhand von in Zeichnungen dargestellter Ausführungsbeispiele näher erläutert. Es zeigen:
- Fig. 1A-E: verschiedene Schritte bei der Herstellung eines Leiterplattenkerns mit Komponenten mit zu einem Träger weisenden Kontakten ("Embedded Kern - Face Down"),
- Fig. 2A-E: verschiedene Schritte bei der Herstellung eines alternativen Leiterplattenkerns mit Komponenten mit vom Träger weg weisenden Kontakten ("Embedded Kern - Face Up"),
- Fig. 3A-C: verschiedene Schritte bei der Herstellung eines weiteren alternativen Leiterplattenkerns mit an einer Vorder- und einer Rückseite fixierten Komponenten (Embedded Außenlage (grob))
- Fig. 4A-F: verschiedene Schritte bei der Herstellung des Leiterplattenkerns der Fig. 3 in einer detaillierteren Darstellung (Embedded Außenlage (fein))

In den Figuren sind funktionell gleiche oder gleich wirkende Elemente jeweils mit denselben Bezugszeichen beziffert. Die Figuren sind schematische Darstellungen der Erfindung. Sie bilden nicht spezifische Parameter der Erfindung ab. Zudem sind die Dimensionen der einzelnen Elemente nicht maßstabsgetreu wiedergegeben. Weiterhin geben die Figuren lediglich typischen Ausgestaltungen der Erfindung wieder und sollen die Erfindung nicht auf die dargestellten Ausgestaltungen beschränken.

Zur Vermeidung unnötiger Wiederholungen wird bei nicht näher beschriebenen Elementen in einer Figur auf die jeweilige Beschreibung der Elemente in vorstehenden Figuren verwiesen.

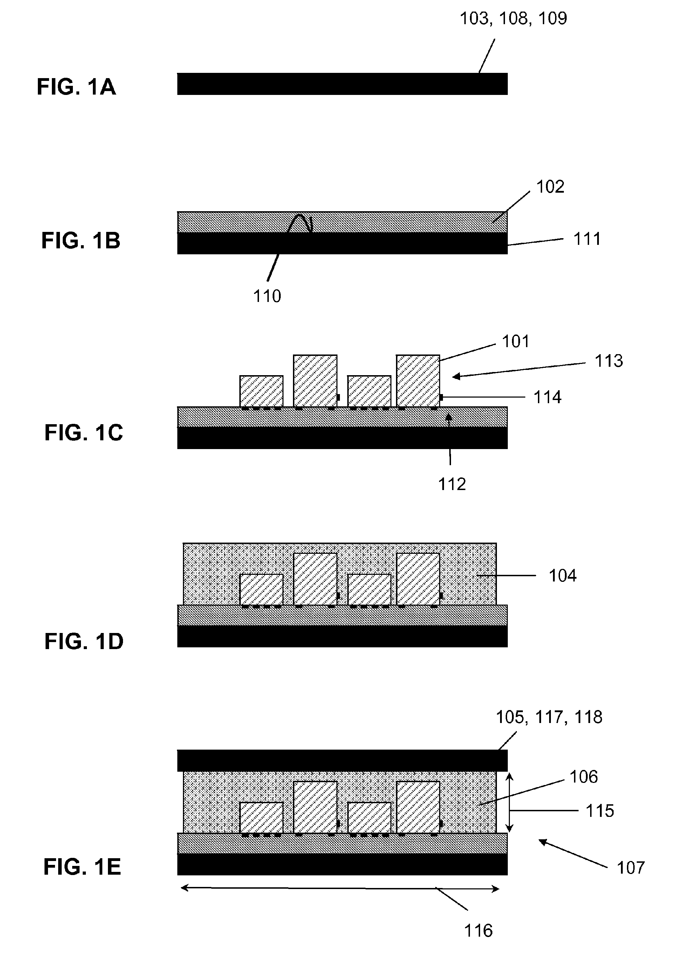

In den Fig. 1A bis 1E ist ein Verfahrensablauf eines Verfahrens zur Einbettung von zumindest einer Komponente 101 in eine dielektrische Lage 106 zur Herstellung eines Leiterplattenkerns 107 gezeigt. Im vorliegenden Ausführungsbeispiel werden vier Komponenten 101 eingebettet. Die Komponenten 101 sind elektrische Komponenten und können ICs, Integrierte Passive Komponenten IPDs, ASICs oder flache passive Komponenten sein. Wie durch die Darstellung unterschiedlich großer Komponenten 101 deutlich wird, werden unterschiedliche Komponenten 101 eingebettet.

Wie in Fig. 1A gezeigt ist wird ein Träger 103 verwendet. Dieser Träger 103 ist von einer ersten elektrisch leitfähigen Lage 108 in der Form einer dünnen Metallfolie 109 gebildet. Gemäß Fig. 1B wird auf diesen Träger 103 in einem Eingangsprozessschritt vor Schritt a) auf den Träger 103 ein Kleber 102 in der Form eines leitenden und unstrukturierten Folienklebers aufgebracht. Die Aufbringung erfolgt auf einer gesamten Oberfläche 110 bzw. einer Ebene des Trägers 103, die eine großflächige Seite des Trägers 103 darstellt. Diese Oberfläche 110 ist keine der vier umlaufenden Kantenflächen 111 des Trägers 103. Alternativ kann der Kleber auf die Komponenten 101 aufgebracht werden, mit dem sie auf den Träger 103 geklebt werden (nicht gezeigt).

Fig. 1C zeigt gemäß Verfahrensschritt a) ein Positionieren und Fixieren von Komponenten 101 auf dem Träger 103, indem diese auf dem Kleber 102 positioniert und fixiert werden. Hierbei weisen die Komponenten 101 auf mindestens einer Seite 112, 113 bzw. auf einer zur Oberfläche 110 weisenden Seite 112 und im Fall der großen Komponenten 101 an einer Seite 113, deren Ebene sich senkrecht zu der Oberfläche 110 erstreckt, je zumindest einen Kontakt 114 bzw. mehrer Kontakte 114 auf. Die ein oder mehreren Kontakte 114 sind insbesondere elektrische Kontakte. Somit sind die Komponenten 101 mit den Kontakten 114 nach unten und seitlich orientiert auf dem Träger 103 platziert. Die unterschiedlichen Komponenten 101 weisen eine voneinander abweichende Anzahl von Kontakten 114 auf. In der Komponentenlage sind Komponenten 101 mit Kontakten 114 nach unten und seitlich orientiert gemischt angeordnet.

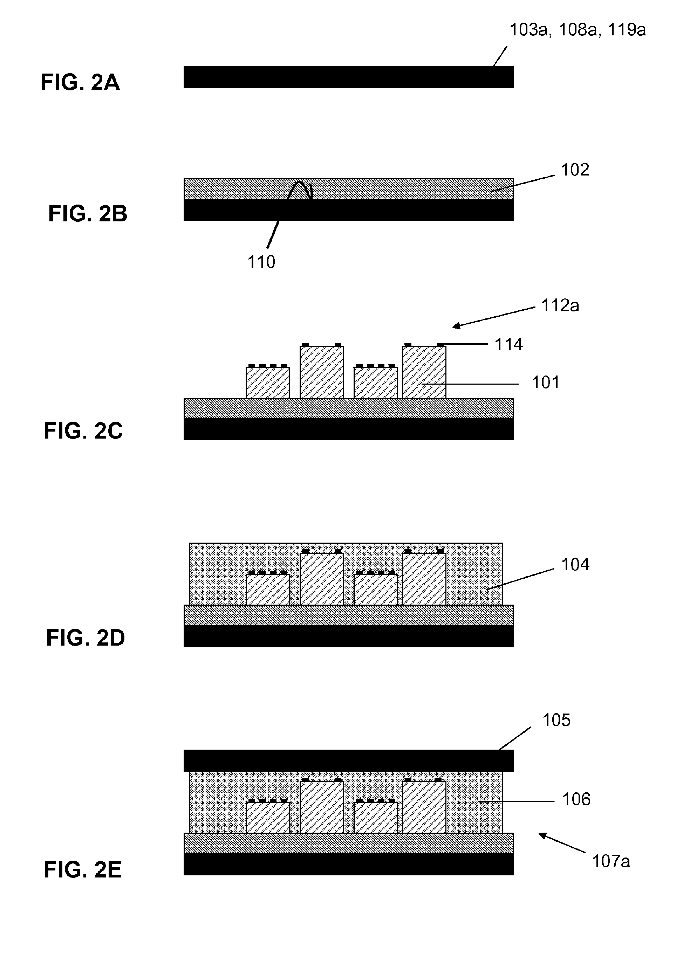

Alternativ könnten Komponenten auf nach oben orientierte Kontakte aufweisen (vgl. Fig. 2), die ebenso in der Komponentenlage gemischt mit den Komponenten 101 mit Kontakten 114 nach unten und seitlich orientiert angeordnet sein können (nicht gezeigt).

In Fig. 1D ist der Aufbau nach den Verfahrensschritten b) und c) gezeigt. Hierbei wurden die Komponenten 101 mittels Siebdruck mit einem flüssigen Dielektrikum 104 umgossen, so dass die Komponenten 101 vollständig umschlossen sind. Das flüssige Dielektrikum 104 ist ein Thermoplast bzw. ein Polyimid. Hierbei hat sich insbesondere das Polyimid Sunflex von Sun Chemical bewährt. Im Anschluss an das Umgießen der Komponenten 101 erfolgte das Aushärten des flüssigen Dielektrikums 104 zu einer festen dielektrischen Lage 106. Dies erfolgt mittels Einwirkung von Wärme. Das Dielektrikum weist im ausgehärteten Zustand eine Dicke 115 senkrecht zur Oberfläche 110 von 150 µm auf. Ferner erstreckt sich das Dielektrikum parallel zur Oberfläche 110 im Wesentlichen entlang eine gesamten Erstreckung 116 des Trägers 103.

Wie in Fig. 1E dargestellt ist, wird gemäß Verfahrensschritt d) im Anschluss an das Aushärten eine weitere Lage 117 bzw. eine elektrisch leitfähigen Lage auflaminiert. Die weitere elektrisch leitfähige Lage ist von einer Metallfolie bzw. einer Kupferfolie 118 gebildet. Die Komponenten 101 werden in einem Nachfolgenden Verfahrensschritt e) an die elektrisch leitfähigen Lagen 106, 117 bzw. den Träger 103 und der Kupferfolie 118 mittels plattierten Sacklöchern elektrisch angeschlossen (nicht im Detail gezeigt).

Das beschriebene Verfahren zeigt eine Verwendung des komplett aus flüssigem Dielektrikums 104 aufgebauten dielektrischen Lage 106, wobei das flüssige Dielektrikum 104 erst bei der Prozessierung des Dielektrikums in einen festen Zustand überführt wird.

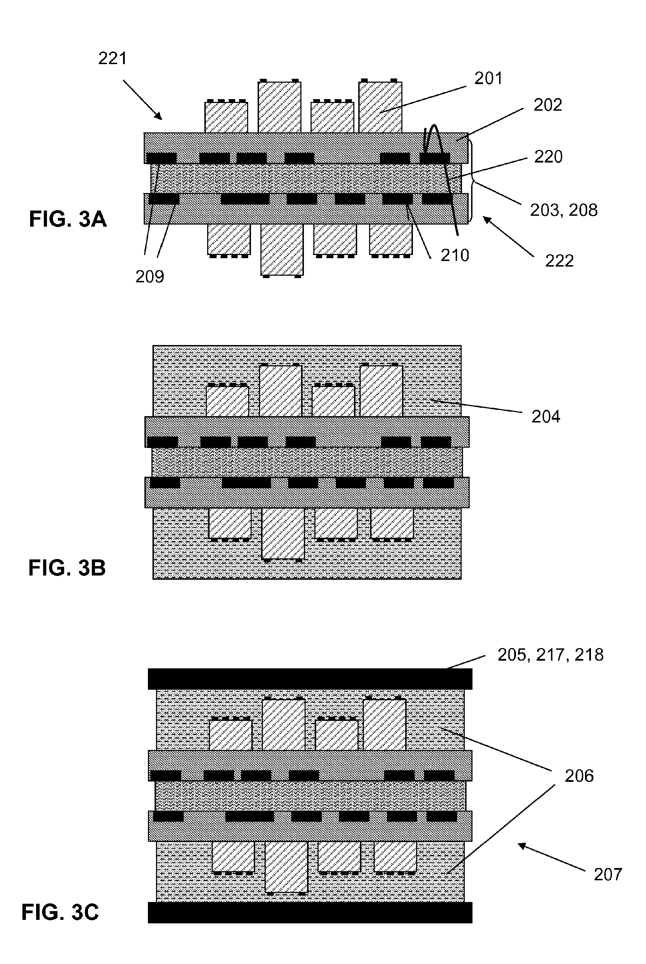

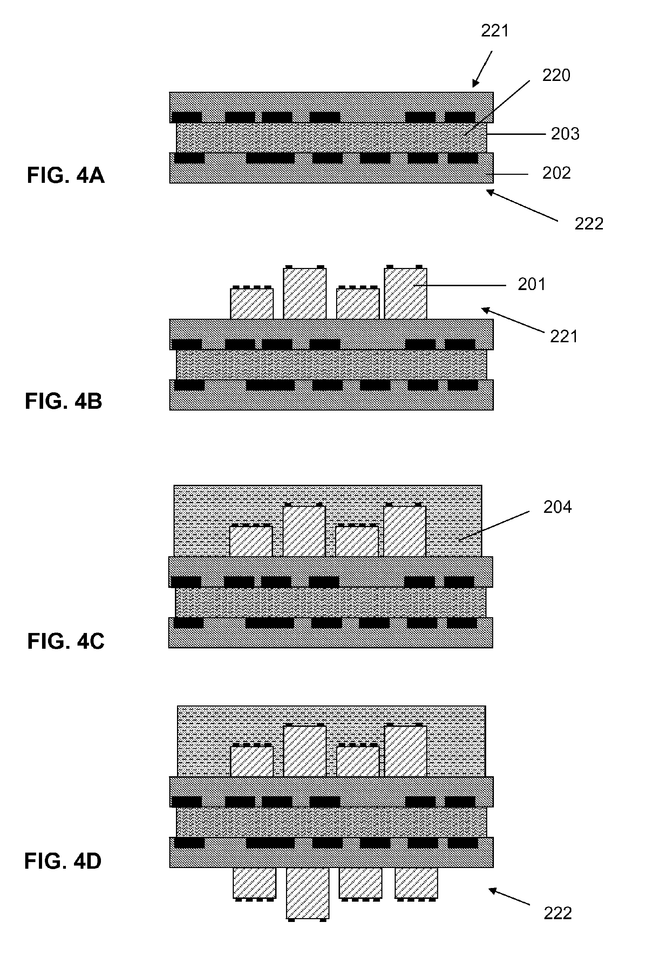

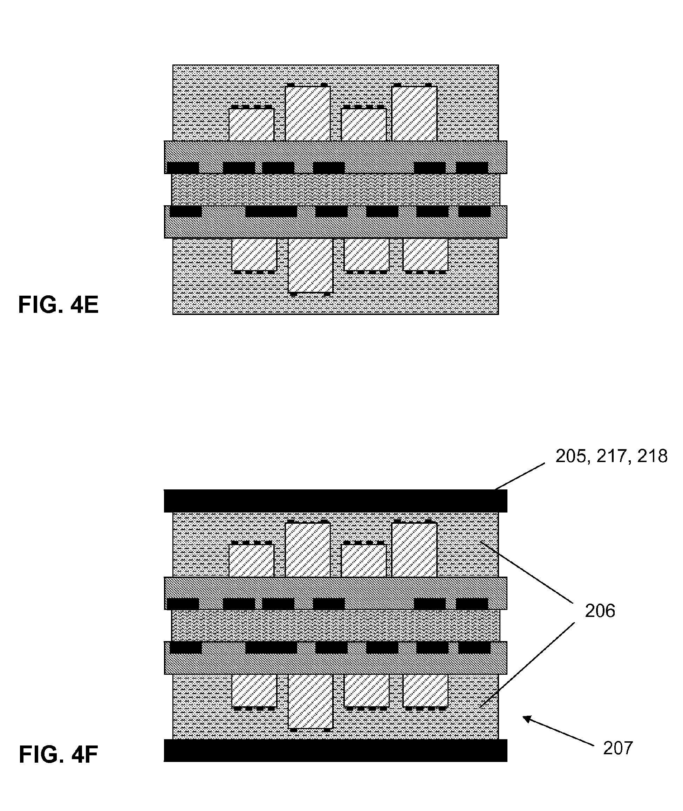

In den Figuren 2 bis 4 sind alternative Ausführungsbeispiele des Verfahrens dargestellt. Im Wesentlichen sind gleich bleibende Bauteile, Merkmale und Funktionen grundsätzlich mit den gleichen Bezugszeichen beziffert. Zur Unterscheidung der Ausführungsbeispiele der Fig. 1 und 2 ist jedoch einzelnen Bezugszeichen der Fig. 2 der Buchstaben a hinzugefügt. Zur Unterscheidung der Ausführungsbeispiele der Fig. 1 und 3 bzw. 4 sind die Bezugszeichen der Fig. 3 und 4 um 100 erhöht. Die nachfolgende Beschreibung beschränkt sich im Wesentlichen auf die Unterschiede zu dem Ausführungsbeispiel in der Fig. 1, wobei bezüglich gleich bleibender Bauteile, Merkmale und Funktionen auf die Beschreibung des Ausführungsbeispiels in der Fig. 1 verwiesen werden kann.

Das Ausführungsbeispiel der Fig. 2 unterscheidet sich von dem der Fig. 1 darin, dass ein Träger 103a eines Leiterplattenkerns 107a von einer ersten elektrisch leitfähigen Lage 108a in der Form einer weiteren Lage 119a einer Leiterplatte gebildet ist. Ferner werden im Verfahrensschritt a) die Komponenten 101 so auf dem Träger 103a platziert und fixiert, dass Kontakte 114 der Komponenten 101 an einer Seite 112a angeordnet sind, die von einer Oberfläche 110 weg wiest. Somit sind die Komponenten 101 mit den Kontakten 114 nach oben orientiert auf dem Träger 103a platziert (Fig. 2C - 2E).

Die Figuren 3 und 4 zeigen in einer groben und einer detaillierteren Darstellung eine Herstellung eines weiteren alternativen Leiterplattenkerns 207. Hierbei wird ein Träger 203 als eine erste leitfähige Lage 208 von zwei durch eine Trennschicht 220 beabstandete Gitter aus Metallfolie 209 gebildet. Auf die jeweils von dem benachbarten Gitter weg weisenden Oberflächen 210 bzw. der Trennschicht 220 ist ein Kleber 202 aufgebracht (Fig. 4A). Wie Fig. 3A zeigt, werden gemäß Schritt a) Komponenten 201 auf dem Träger 203 bzw. dem Kleber 202 positioniert und fixiert. Dies kann, wie in Fig. 3A dargestellt ist, vor den Verfahrensschritten b) an c) auf beiden Oberflächen 210, also einer Vorderseite 221 und einer Rückseite 222, des Trägers 203 erfolgen.

Wie in Fig. 4 gezeigt ist, kann dieser Vorgang auch stufenweise erfolgen. Hierbei werden nach der Positionierung der Komponenten 201 auf der Vorderseite 221 (Fig. 4B) die Komponenten 201 mit einem flüssigen Dielektrikum 204 umgossen, so dass die Komponenten 201 vollständig umschlossen sind, und des flüssigen Dielektrikums 204 zu einer festen dielektrischen Lage 206 ausgehärtet (Fig. 4C). Erst hiernach werden Komponenten 203 auf der Rückseite 222 positioniert (Fig. 4D) und mit flüssigem Dielektrikum 204 vollständig umgossen und dieses zu einer festen dielektrischen Lage 207 ausgehärtet (Fig. 4E).

Die Figuren 3C und 4F zeigen nun den Leiteplattenkern 207 nach Verfahrenschritt d) dem Auflaminieren einer weiteren Lage 205 bzw. einer elektrisch leitfähigen Lage 217 in der Form einer Kupferfolie 218.

### Bezugszeichenliste:

- 101: Komponenten
- 102: Kleber
- 103: Träger
- 104: flüssiges Dielektrikum
- 105: weitere leitfähige Lage
- 106: dielektrische Lage
- 107: Leiterplattenkern
- 108: erste elektrisch leitfähige Lage
- 109: Metallfolie
- 110: Oberfläche
- 111: Kantenfläche
- 112: Seite
- 113: Seite
- 114: Kontakt
- 115: Dicke
- 116: Erstreckung
- 117: Lage
- 118: Kupferfolie
- 119a: weitere Lage
- 201: Komponenten
- 202: Kleber
- 203: Träger
- 204: flüssiges Dielektrikum
- 205: weitere leitfähige Lage
- 206: dielektrische Lage
- 207: Leiterplattenkern
- 208: erste elektrisch leitfähige Lage
- 209: Metallfolie
- 210: Oberfläche
- 217: elektrisch leitfähige Lage
- 218: Kupferfolie
- 220: Trennschicht
- 221: Vorderseite
- 222: Rückseite

## Patentansprüche

1. Verfahren zur Einbettung von zumindest einer Komponente (101, 201) in eine dielektrische Lage (106, 206), wobei das Verfahren die folgenden Schritte umfasst:
a) Positionieren und Fixieren der zumindest einen Komponente (101, 201) auf einem Träger (103, 103a, 203),
b) Umgießen der zumindest einen Komponente (101, 201) mit einem flüssigen Dielektrikum (104, 204), so dass die zumindest eine Komponente (101, 201) vollständig umschlossen wird,
c) Aushärten des flüssigen Dielektrikums (104, 204) zu einer festen dielektrischen Lage (106, 206), und
d) Aufbringen einer weiteren Lage (105, 205), insbesondere einer elektrisch leitfähigen Lage (117, 217).

2. Verfahren nach Anspruch 1, **dadurch gekennzeichnet, dass** das Dielektrikum mit einer Mindestdicke von 10 µm (im ausgehärteten Zustand), mit einer maximalen Dicke von 1000 µm und einer bevorzugten Dicke (115, 215) von 30 - 250 µm ausgebildet wird.

3. Verfahren nach Anspruch 1 oder 2, **dadurch gekennzeichnet, dass** das flüssige Dielektrikum (104, 204) von einem Thermoplast und/oder einem Duroplast gebildet wird und/oder insbesondere von einem Element aus der Gruppe bestehend aus: Polyimid, Epoxidharz, Polyesterharz, Polyurethan und Aminoharz.

4. Verfahren nach einem der vorangegangenen Ansprüche, **dadurch gekennzeichnet, dass** der Träger (103, 203) von zumindest einer ersten elektrisch leitfähigen Lage (108, 208), insbesondere einer Metallfolie (109, 209), gebildet wird.

5. Verfahren nach einem der Ansprüche 1 bis 3, **dadurch gekennzeichnet, dass** der Träger (103a) von einer ersten elektrisch leitfähigen Lage (108a), insbesondere von einer weiteren Lage (119a) einer Leiterplatte, gebildet wird.

6. Verfahren nach einem der vorangegangenen Ansprüche, **dadurch gekennzeichnet, dass** die weitere elektrisch leitfähige Lage (105, 205) gebildet wird aus einem Element der Gruppe bestehend aus einer Metallfolie (109, 209), insbesondere einer Kupferfolie (118, 218), einer thermoplastischen Polymerfolie oder eines metallkaschierten Duromeres.

7. Verfahren nach einem der vorangegangenen Ansprüche, **dadurch gekennzeichnet, dass** mindestens eine weitere dielektrische Klebeschichtlage auf der der elektrisch leitfähigen Lage zugewandten Seite der ersten dielektrischen Lage aufgebracht wird.

8. Verfahren nach einem der vorangegangenen Ansprüche, **dadurch gekennzeichnet, dass** das Umgießen mittels einem Verfahren durchgeführt wird aus der Gruppe bestehend aus Siebdruck, Rakelverfahren, "Curtain coating", Laminierverfahren, Flexodruck oder Gravurdruck.

9. Verfahren nach einem der vorangegangenen Ansprüche, **dadurch gekennzeichnet, dass** eine Komponente (101, 201) verwendet wird, die auf mindestens einer Seite (112, 112a, 113, 212) zumindest einen elektrischen oder thermischen Kontakt (114, 214) aufweist.

10. Verfahren nach Anspruch 9, **dadurch gekennzeichnet, dass** zumindest eine Komponente (101, 201) mit zumindest einem elektrischen oder thermischen Kontakt (114, 214) nach oben orientiert und/oder nach orientiert unten und/oder seitlich orientiert auf dem Träger (103, 203) platziert wird.

11. Verfahren nach Anspruch 9 oder 10, **dadurch gekennzeichnet, dass** in einer Komponentenlage Komponenten (101, 201) mit einem elektrischen oder thermischen Kontakt (114, 214) unten und/oder oben und/oder seitlich und/oder mit mehreren elektrischen Kontakten (114, 214) unten und/oder oben und/oder seitlich gemischt angeordnet werden.

12. Verfahren nach einem der vorangegangenen Ansprüche, **dadurch gekennzeichnet, dass** das Verfahren einen Eingangsprozessschritt vor Schritt a) aufweist, bei dem auf den Träger (103, 203) ein Kleber (102, 202) aufgebracht wird, auf dem die Komponenten (101, 201) positioniert und fixiert werden und/oder bei dem ein Kleber (102, 202) auf die Komponenten (101, 201) aufgebracht wird, mit dem sie auf den Träger (103, 203) geklebt werden.

13. Verfahren nach einem der vorangegangenen Ansprüche, **dadurch gekennzeichnet, dass** die zumindest eine Komponente (101, 201) an die leitfähigen Lagen (105, 205, 108, 208) mittels plattierten Löchern zwischen den Lagen oder mittels Leitkleber elektrisch oder thermisch angeschlossen wird.

14. Verfahren nach einem der vorangegangenen Ansprüche, **dadurch gekennzeichnet, dass** die zumindest eine Komponente (101, 201) gebildet wird von einer elektrischen Komponente und/oder insbesondere von einer Komponente aus der Gruppe bestehend aus ICs, IPDs, ASICs, Leistungsverstärker, RFIDs oder flache passive Komponenten.

15. Verwendung einer komplett aus flüssigem Dielektrikum aufgebauten dielektrischen Lage, wobei das flüssige Dielektrikum erst bei der Prozessierung des Dielektrikums in einen festen Zustand überführt wird.
